# EUROPÄISCHE PATENTANMELDUNG

(11) **EP 1 480 252 A1**
(43) Veröffentlichungstag der Anmeldung: **24.11.2004**
(21) Anmeldenummer: 03011732.9
(22) Anmeldetag: 23.05.2003
(51) Int. Cl.: H01L 21/00

(54) **Vorrichtung zum Behandeln einer Halbleiterscheibe**

(71) Anmelder: silicet AG, 34253 Lohfelden (DE)
(72) Erfinder: Moritz, Hans, 34253 Lohfelden (DE)

(57) **Zusammenfassung**

Vorrichtung zum Behandeln einer Halbleiterscheibe, bestehend aus einem Grundkörper mit Rückwand und parallel zur Rückwand angeordnetem lösbar am Grundkörper gehaltenen Deckel. Zwischen Rückwand und Deckel ist zumindest eine Aufnahmekammer für ein fluides Arbeitsmedium angeordnet. Die zu behandelnde Halbleiterscheibe ist mit einer am Rand der Halbleiterscheibe entlanglaufenden Dichtungsanordnung am Grundkörper mit der Maßgabe fixiert, dass die Halbleiterscheibe eine Begrenzungswand der Aufnahmekammer bildet. Es ist zumindest eine Zuführungsleitung und zumindest eine Abführungsleitung für das Arbeitsmedium an die Aufnahmekammer angeschlossen und die Aufnahmekammer ist ansonsten geschlossen ausgebildet.

## Beschreibung

Die Erfindung betrifft eine Vorrichtung zum Behandeln einer Halbleiterscheibe, bestehend aus einem Grundkörper mit einer Rückwand und einem parallel zur Rückwand angeordneten lösbar am Grundkörper gehaltenen Deckel. Eine solche Halbleiterscheibe wird auch als Wafer bezeichnet. Die Behandlung der Halbleiterscheibe meint beispielsweise ein Ätzen der Halbleiterscheibe.

Vorrichtungen der eingangs genannten Art sind aus der Praxis grundsätzlich bekannt. Diese Vorrichtungen sind in der Regel als Haltevorrichtungen zur Aufnahme der Halbleiterscheibe ausgebildet. Es wird dafür Sorge getragen, dass eine Seite bzw. Oberfläche der Halbleiterscheibe gegenüber der Umgebung gleichsam abgedichtet ist und die andere Oberfläche bzw. Seite der Halbleiterscheibe frei liegt und somit von einem Arbeitsmedium beaufschlagt werden kann. Die Haltevorrichtung mit der aufgenommenen Halbleiterscheibe wird dann normalerweise in ein Bad des Arbeitsmediums, beispielsweise in ein Ätzbad eingetaucht. Diese bekannten Maßnahmen sind mit einem relativ hohen Verbrauch an Arbeitsmedium bzw. Ätzmittel verbunden. Außerdem sind freie Oberflächen eines oftmals giftigen und aggressiven Arbeitsmediums vorhanden, so dass die Gefahr des Berührungskontaktes mit diesen Medien relativ groß ist. Fernerhin können an diesen freien Oberflächen unerwünschte Ausgasungen stattfinden. - Nach der Behandlung der Halbleiterscheibe wird die Haltevorrichtung in der Regel aus dem Becken mit Arbeitsmedium, beispielsweise aus dem Ätzbecken in ein Spülbecken überführt. Um dort eine ungewollte Oxidation der Scheibenoberfläche zu vermeiden wird normalerweise eine sogenannte Verdrängungsspülung durchgeführt. Dabei wird das Arbeitsmedium durch ein Spülmedium kontinuierlich verdünnt und weggespült. Bei aggressiven Arbeitsmedien kann das aber zu einer hohen Belastung der Vorrichtungskomponenten und bei Vorrichtungen mit Elektroden bis zur Zerstörung dieser Elektroden führen.

Demgegenüber liegt der Erfindung das technische Problem zugrunde, eine Vorrichtung der eingangs genannten Art anzugeben, mit der eine einfache und funktionssichere Behandlung einer Halbleiterscheibe möglich ist und bei der die vorstehend beschriebenen Nachteile effektiv vermieden werden können.

Zur Lösung dieses technischen Problems lehrt die Erfindung eine Vorrichtung zum Behandeln einer Halbleiterscheibe (Wafer), bestehend aus einem Grundkörper mit einer Rückwand und einem parallel zur Rückwand angeordneten lösbar am Grundkörper gehaltenen Deckel,
wobei zwischen Rückwand und Deckel zumindest eine Aufnahmekammer für ein fluides Arbeitsmedium angeordnet ist,
wobei die zu behandelnde Halbleiterscheibe mit einer am Rand der Halbleiterscheibe entlanglaufenden Dichtungsanordnung zwischen Rückwand und Deckel am Grundkörper mit der Maßgabe fixierbar ist, dass die Halbleiterscheibe eine Begrenzungswand der Aufnahmekammer bildet und ihre aufnahmekammerseitige Oberfläche von dem Arbeitsmedium beaufschlagbar ist,
und wobei zumindest eine Zuführungsleitung für das Arbeitsmedium und zumindest eine Abführungsleitung für das Arbeitsmedium an die Aufnahmekammer angeschlossen ist und die Aufnahmekammer ansonsten geschlossen gegenüber ihrer Umgebung ausgebildet ist. Abgesehen von der Zuführungsleitung und der Abführungsleitung ist also erfindungsgemäß die Aufnahmekammer gegenüber der Umgebung abgedichtet. Abdichtung meint hier, dass das fluide Medium außer über die Zuführungsleitung und die Abführungsleitung nicht in die bzw. aus der Vorrichtung gelangen kann. - Wie oben bereits dargelegt meint die Behandlung der Halbleiterscheibe insbesondere ein Ätzen der Halbleiterscheibe. Mit Arbeitsmedium ist dann ein Ätzmedium bzw. Ätzmittel gemeint.

Der Erfindung liegt die Erkenntnis zugrunde, dass eine erfindungsgemäße Vorrichtung gleichsam selbst als Behandlungsanlage bzw. als Becken für das Arbeitsmedium funktionieren kann. Die Vorrichtung selbst bildet also eine kleine Ätzanlage oder Galvanikanlage zur Behandlung der Halbleiterscheibe. Diese Vorrichtung arbeitet überraschend funktionssicher und effektiv.

Nach sehr bevorzugter Ausführungsform der Erfindung ist der Grundkörper der Vorrichtung plattenförmig ausgebildet und die Breite b des Aggregates aus Grundkörper, Rückwand und Deckel ist geringer als der Durchmesser der Halbleiterscheibe, vorzugsweise geringer als die Hälfte des Durchmessers der Halbleiterscheibe. Auf diese Weise wird eine Vorrichtung mit geringem Volumen verwirklicht und diese Vorrichtung zeichnet sich insbesondere durch einen geringen Verbrauch von Arbeitsmedium aus. Es liegt im Übrigen im Rahmen der Erfindung, dass das Arbeitsmedium über die Zuführungsleitung kontinuierlich zugeführt und über die Abführungsleitung kontinuierlich abgeführt wird. Dadurch wird die Aufnahmekammer kontinuierlich von dem Arbeitsmedium durchströmt. Mit anderen Worten wird das mit der einen Oberfläche der Halbleiterscheibe in Kontakt stehende Arbeitsmedium ständig erneuert. Es versteht sich, dass für die Zuführung bzw. Abführung des Arbeitsmediums eine geeignete Pumpe eingesetzt werden kann.

Zweckmäßigerweise wird die Halbleiterscheibe mit Hilfe einer Dichtungsanordnung aus zwei mit Abstand voneinander angeordneten elastischen Dichtungen am Grundkörper gehalten. Nach einer bevorzugten Ausführungsform sind die beiden elastischen Dichtungen konzentrisch um zumindest einen Teil der Aufnahmekammer herum angeordnet. Vorzugsweise sind die elastischen Dichtungen als Lippendichtungen ausgebildet. Nach sehr bevorzugter Ausführungsform, der im Rahmen der Erfindung ganz besondere Bedeutung zukommt, mündet zwischen den beiden elastischen Dichtungen zumindest eine Unterdruckleitung. Die Halbleiterscheibe kann also durch Erzeugung eines Unterdruckes bzw. Vakuums an der Dichtungsanordnung bzw. an den beiden elastischen Dichtungen fixiert werden.

Nach bevorzugter Ausführungsform der Erfindung ist der Deckel mit Hilfe einer zweiten, vorzugsweise konzentrisch um die erste Dichtungsanordnung herum angeordneten Dichtungsanordnung am Grundkörper gehalten. Vorzugsweise besteht die zweite Dichtungsanordnung aus zwei mit Abstand voneinander angeordneten elastischen Dichtungen, die zweckmäßigerweise als Lippendichtungen ausgebildet sind. Bevorzugt mündet zwischen den beiden elastischen Dichtungen eine Unterdruckleitung. Vorzugsweise wird also auch der Deckel durch Erzeugung eines Unterdruckes bzw. Vakuums am Grundkörper fixiert.

Nach einer Ausführungsform der Erfindung ist die Rückwand lösbar am Grundkörper gehalten. Bei dieser Ausführungsform funktioniert die Rückwand also ebenfalls als ein Deckel bzw. zweiter Deckel. Zweckmäßigerweise kann die Rückwand mit Hilfe einer dritten Dichtungsanordnung am Grundkörper gehalten werden, wobei diese dritte Dichtungsanordnung vorzugsweise aus zwei mit Abstand voneinander angeordneten elastischen Dichtungen besteht. Diese elastischen Dichtungen sind bevorzugt als Lippendichtungen ausgeführt. Nach sehr bevorzugter Ausführungsform mündet zwischen den beiden elastischen Dichtungen der dritten Dichtungsanordnung eine Unterdruckleitung. Auch der lösbare Deckel wird hier durch Erzeugung eines Unterdruckes bzw. Vakuums am Grundkörper fixiert.

Nach einer weiteren Ausführungsform der Erfindung werden der Deckel und die Rückwand über Schraubverbindungen mit dem Grundkörper verbunden. Wenn bei dieser Ausführungsform zum Halten der Halbleiterscheibe und/oder des Deckels und/oder der Rückwand jeweils eine Dichtungsanordnung aus zwei elastischen Dichtungen eingesetzt wird, ist es grundsätzlich nicht erforderlich, dass eine Unterdruckleitung zwischen den beiden elastischen Dichtungen mündet.

Die erfindungsgemäße Vorrichtung lässt sich sehr effektiv bei galvanischen Behandlungsprozessen einsetzen. Dabei ist die Halbleiterscheibe vorzugsweise als Elektrode geschaltet und in der Aufnahmekammer ist eine Gegenelektrode angeordnet.

Nach sehr bevorzugter Ausführungsform ist die erfindungsgemäße Vorrichtung zum einseitigen Behandeln einer Halbleiterscheibe vorgesehen und weist dann lediglich eine Aufnahmekammer auf. Die aufnahmekammerseitige Oberfläche der Halbleiterscheibe wird von dem Arbeitsmedium beaufschlagt. Nach einer anderen Ausführungsform kann die Vorrichtung aber auch zum beidseitigen Behandeln einer Halbleiterscheibe vorgesehen sein und die Halbleiterscheibe trennt dann als Begrenzungswand zwei Aufnahmekammern, so dass beide aufnahmekammerseitigen Oberflächen der Halbleiterscheibe von dem Arbeitsmedium beaufschlagt werden. Bei der Vorrichtung zum beidseitigen Behandeln der Halbleiterscheibe ist zweckmäßigerweise an jede Aufnahmekammer eine Zuführungsleitung und eine Abführungsleitung für das Arbeitsmedium angeschlossen.

Der Erfindung liegt die Erkenntnis zugrunde, dass mit der erfindungsgemäßen Vorrichtung eine sehr funktionssichere und effektive Behandlung von Halbleiterscheiben möglich ist. Hervorzuheben ist, dass sich die Behandlung mit der erfindungsgemäßen Vorrichtung durch einen überraschend geringen Verbrauch an Arbeitsmedium auszeichnet. Durch die erfindungsgemäße Ausgestaltung der Vorrichtung wird auch ein Berührungskontakt mit giftigen bzw. aggressiven Arbeitsmedien vermieden. Ausgasungen an offenen Oberflächen finden nicht statt. Wenn die erfindungsgemäße Vorrichtung in ein Becken mit Spülmedium, beispielsweise mit Wasser eingestellt wird, kann austretendes Arbeitsmedium sofort stark verdünnt werden, so dass negative Folgen nicht zu befürchten sind. Im Ergebnis zeichnet sich die Vorrichtung vor allem durch einen geringen Medienverbrauch und somit auch durch einen geringen Energieverbrauch aus.

Nachfolgend wird die Erfindung anhand einer lediglich ein Ausführungsbeispiel darstellenden Zeichnung näher erläutert. Es zeigen in schematischer Darstellung:
- **Fig. 1**: einen Schnitt durch eine erfindungsgemäße Vorrichtung in einer ersten Ausführungsform,
- **Fig. 2**: den Gegenstand gemäß Fig. 1 in einer zweiten Ausführungsform,
- **Fig. 3**: den Gegenstand nach Fig. 1 in einer dritten Ausführungsform,
- **Fig. 4**: eine perspektivische Ansicht einer erfindungsgemäßen Vorrichtung,
- **Fig. 5**: einen Schnitt durch eine erfindungsgemäße Vorrichtung in einer vierten Ausführungsform mit angeschlossenen Komponenten und
- **Fig. 6**: einen Schnitt durch eine erfindungsgemäße Vorrichtung in einer fünften Ausführungsform.

Die Figuren zeigen eine Vorrichtung zum einseitigen Behandeln einer Halbleiterscheibe 1 bzw. eines Wafers. Die Vorrichtung besteht aus einem Grundkörper 2 mit einer Rückwand 3 und einem parallel zur Rückwand 3 angeordneten lösbar am Grundkörper 2 gehaltenen Deckel 4. Zwischen Rückwand 3 und Deckel 4 ist eine Aufnahmekammer 5 für ein fluides Arbeitsmedium 6 angeordnet. Die zu behandelnde Halbleiterscheibe 1 ist mit einer am Rand der Halbleiterscheibe 1 entlanglaufenden ersten Dichtungsanordnung 7 zwischen Rückwand 3 und Deckel 4 am Grundkörper 2 mit der Maßgabe fixiert, dass die Halbleiterscheibe 1 eine Begrenzungswand der Aufnahmekammer 5 bildet und lediglich ihre aufnahmekammerseitige Oberfläche 8 von dem Arbeitsmedium 6 beaufschlagt wird. Im Ausführungsbeispiel ist eine Zuführungsleitung 9 und eine Abführungsleitung 10 für das Arbeitsmedium 6 an die Aufnahmekammer 5 angeschlossen. Ansonsten ist die Aufnahmekammer 5 geschlossen bzw. abgedichtet gegenüber der Umgebung ausgebildet. Das Arbeitsmedium 6 wird über die Zuführungsleitung 9 kontinuierlich zugeführt und über die Abführungsleitung 10 ebenso kontinuierlich abgeführt. Folglich wird die Aufnahmekammer 5 kontinuierlich von dem Arbeitsmedium 6 durchströmt.

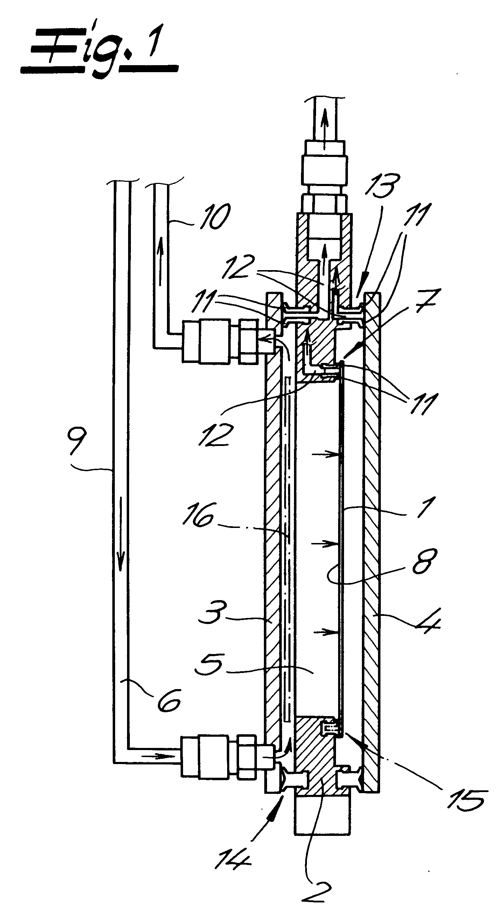

Vorzugsweise und bei allen Ausführungsformen nach den Figuren wird die Halbleiterscheibe 1 mit Hilfe einer ersten Dichtungsanordnung 7 aus zwei mit Abstand voneinander angeordneten elastischen Dichtungen 11 am Grundkörper fixiert. Zweckmäßigerweise und im Ausführungsbeispiel sind diese elastischen Dichtungen 11 als Lippendichtungen ausgeführt. Vorzugsweise und bei den Ausführungsformen nach den Fig. 1 bis 5 mündet zwischen den beiden elastischen Dichtungen 11 eine Unterdruckleitung 12. Durch Aufbringung eines Unterdruckes kann die Halbleiterscheibe 1 somit sicher an der ersten Dichtungsanordnung 7 fixiert werden. Bei den Ausführungsformen nach den Fig. 1 bis 5 ist fernerhin der Deckel 4 mit Hilfe einer zweiten, konzentrisch um die erste Dichtungsanordnung 7 herum angeordnete Dichtungsanordnung 13 an dem Grundkörper 2 fixiert. Diese zweite Dichtungsanordnung 13 besteht im Ausführungsbeispiel nach den Fig. 1 bis 5 ebenfalls aus zwei mit Abstand voneinander angeordneten elastischen Dichtungen 11, die vorzugsweise als Lippendichtungen ausgebildet sind. Zweckmäßigerweise mündet zwischen den beiden elastischen Dichtungen 11 ebenfalls die Unterdruckleitung 12. Durch Aufbringen eines Unterdruckes kann also bei den Ausführungsformen nach den Fig. 1 bis 5 auch der Deckel 4 funktionssicher am Grundkörper 2 befestigt werden.

Die in Fig. 1 dargestellte Ausführungsform der erfindungsgemäßen Vorrichtung ist insbesondere für ein Ätzen einer Halbleiterscheibe 1 geeignet. Die Halbleiterscheibe 1 befindet sich hier zwischen dem Deckel 4 und der Aufnahmekammer 5. Die Aufnahmekammer 5 wird von der Halbleiterscheibe 1 und von der Rückwand 3 begrenzt und von dem Arbeitsmedium 6 kontinuierlich durchströmt. Die Rückwand 3 ist bei dieser Ausführungsform lösbar am Grundkörper 2 gehalten und zwar mit Hilfe einer dritten Dichtungsanordnung 14, die aus zwei elastischen Dichtungen 11 besteht, die im Ausführungsbeispiel als Lippendichtungen ausgebildet sind. Zwischen diesen beiden elastischen Dichtungen 11 mündet die Unterdruckleitung 12. Durch Aufbringen eines Unterdruckes kann bei dieser Ausführungsform also auch die Rückwand 3 am Grundkörper 2 fixiert werden. Die in Fig. 1 dargestellte Vorrichtung kann von ihrem grundsätzlichen Aufbau her auch für galvanische Prozesse eingesetzt werden. Dazu ist in Fig. 1 angedeutet worden, dass die Halbleiterscheibe 1 als Kathode 15 geschaltet werden kann. Dementsprechend ist in Fig. 1 strichpunktiert eine Anode 16 angedeutet worden, die sich in der Aufnahmekammer 5 befindet.

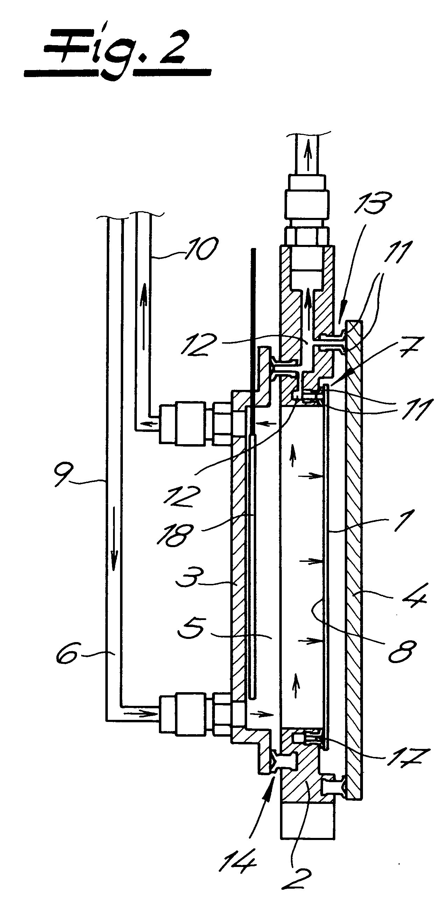

Die Ausführungsform nach Fig. 2 ähnelt der Ausführungsform gemäß Fig. 1. Fig. 2 zeigt eine Vorrichtung, die insbesondere für das Auftragen von Foto-Resist-Lacken auf Halbleiterscheiben 1 geeignet ist. Mit Hilfe gefederter Kontaktstifte 17 ist dazu die Halbleiterscheibe 1 als Elektrode geschaltet. In der Aufnahmekammer 5 befindet sich eine entsprechende Gegenelektrode 18. Die Aufnahmekammer zwischen Halbleiterscheibe 1 und Rückwand 3 ist mit dem Lack als Arbeitsmedium 6 gefüllt bzw. wird von dem Lack kontinuierlich durchströmt. Nach Beendigung des Auftragens wird die Zuführung des Arbeitsmediums 6 bzw. eine entsprechende nicht dargestellte Pumpe abgeschaltet und überschüssiger Lack kann aus der Aufnahmekammer 5 abgesaugt werden. Die erfindungsgemäße Vorrichtung eignet sich insbesondere auch für das Auftragen solcher Lacke, da hier nur geringe Mengen des relativ teuren Lackes erforderlich sind. Insoweit zeichnet sich die Vorrichtung auch durch einen geringen Energieverbrauch aus, da nur kleine Lackmengen zu fördern bzw. zu temperieren sind. Sehr vorteilhaft ist weiterhin, dass nach Benutzung der erfindungsgemäßen Vorrichtung eine aufwändige Reinigung bzw. Entlackung des Scheibenrandes und der Scheibenrückseite nicht erforderlich ist.

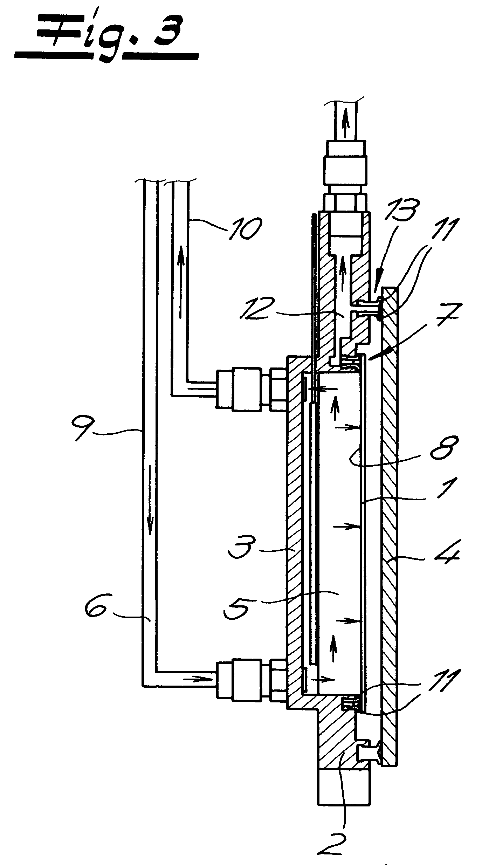

Fig. 3 zeigt eine weitere Ausführungsform der erfindungsgemäßen Vorrichtung, die sich vor allem für das Auftragen von Foto-Resist-Lacken eignet. Hier ist allerdings die Rückwand 3 fest mit dem Grundkörper 2 verbunden. Lediglich die Halbleiterscheibe 1 und der Deckel 4 werden über Dichtungsanordnungen (7, 13) gehalten, an denen die Unterdruckleitung 12 in der bereits beschriebenen Weise mündet.

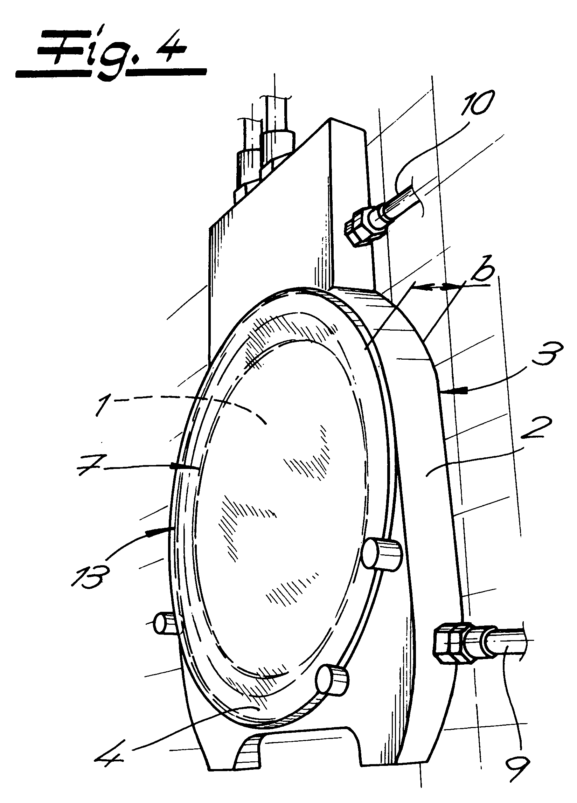

Fig. 4 zeigt eine perspektivische Ansicht einer Ausführungsform einer erfindungsgemäßen Vorrichtung. Es ist erkennbar, dass der Grundkörper 2 plattenförmig ausgebildet ist. Die Breite b des Aggregates aus Grundkörper 2, Rückwand 3 und Deckel 4 ist geringer als der Durchmesser der Halbleiterscheibe 1 und zwar im Ausführungsbeispiel wesentlich geringer als die Hälfte des Durchmessers der Halbleiterscheibe 1. Aus Fig. 4 ist ersichtlich, dass sich die erfindungsgemäße Vorrichtung vor allem durch geringen Raumaufwand auszeichnet. Dadurch, dass eine verhältnismäßig kleine Aufnahmekammer 5 gleichsam als Becken bzw. Bad zum Aufbringen des Arbeitsmediums 6 dient, sind nur geringe Mengen des Arbeitsmediums erforderlich. Es ist noch darauf hinzuweisen, dass in der Fig. 4 der Deckel 4 als Glasdeckel und somit transparent ausgebildet ist, so dass hier die Halbleiterscheibe 1 sichtbar ist.

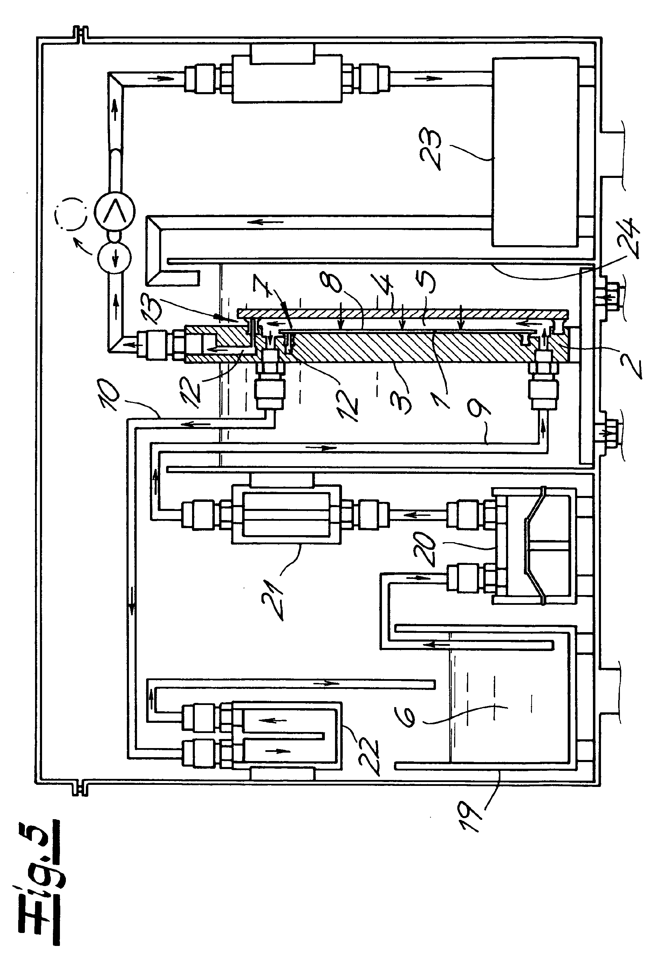

Fig. 5 zeigt eine weitere Ausführungsform einer erfindungsgemäßen Vorrichtung, die insbesondere zum Ätzen einer Halbleiterscheibe 1 geeignet ist. Hier befindet sich die Aufnahmekammer 5 mit dem Arbeitsmedium 6 zwischen dem Deckel 4 und der Halbleiterscheibe 1. Die Rückwand 3 ist unlösbar an dem Grundkörper 2 fixiert. Das Arbeitsmedium 6 wird aus einem Medientank 19 mit Hilfe einer Medienpumpe 20 zugeführt, wobei das Arbeitsmedium 6 mit einer Heizung 21 temperiert wird. Über die Abführungsleitung 10 wird das Arbeitsmedium 6 über einen Filter 22 in den Medientank 19 zurückgeführt. In Fig. 5 ist weiterhin auch eine an die Unterdruckleitung 12 angeschlossene Vakuumpumpe 23 dargestellt. Im Ausführungsbeispiel nach Fig. 5 ist die gesamte Vorrichtung in eine Wanne 24 mit deionisiertem Wasser eingestellt. Falls Arbeitsmedium 6 aus der Vorrichtung austreten sollte, wird dieses durch das deionisierte Wasser sofort hoch verdünnt.

Bei allen Ausführungsformen wird im Übrigen nach Behandeln der Halbleiterscheibe 1 die Medienzufuhr bzw. eine entsprechende Medienpumpe 20 abgeschaltet. Dann wird die Aufnahmekammer 5 zweckmäßigerweise mit deionisiertem Wasser gespült.

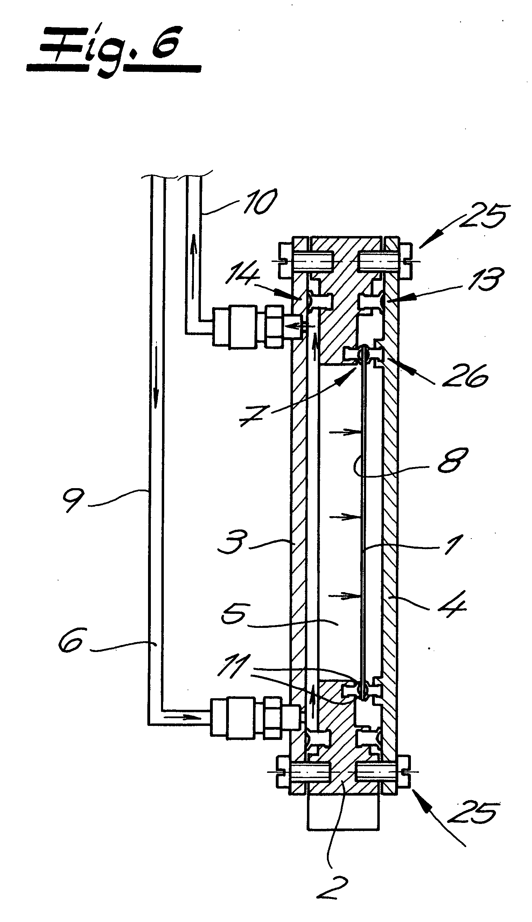

Im Ausführungsbeispiel nach Fig. 6 sind der Deckel 4 und die Rückwand 3 über Schraubverbindungen 25 an dem Grundkörper 2 fixiert. Der Anschluss einer Unterdruckleitung an die Dichtungsanordnungen (7, 13, 14) ist deshalb nicht erforderlich. Bei dieser Ausführungsform ist an den Deckel 4 eine vierte Dichtungsanordnung 26 angeschlossen, die im fixierten Zustand des Deckels 4 gegen die Halbleiterscheibe 1 drückt. Auf diese Weise wird die Halbleiterscheibe 1 sicher fixiert und im Übrigen erfolgt eine effektive Abdichtung gegenüber dem Arbeitsmedium 6.

## Patentansprüche

1. Vorrichtung zum Behandeln einer Halbleiterscheibe (1), bestehend aus einem Grundkörper (2) mit einer Rückwand (3) und einem parallel zur Rückwand (3) angeordneten lösbar am Grundkörper (2) gehaltenen Deckel (4),
wobei zwischen Rückwand (3) und Deckel (4) zumindest eine Aufnahmekammer (5) für ein fluides Arbeitsmedium (6) angeordnet ist,
wobei die zu behandelnde Halbleiterscheibe (1) mit einer am Rand der Halbleiterscheibe (1) entlanglaufenden ersten Dichtungsanordnung (7) zwischen Rückwand (3) und Deckel (4) am Grundkörper (2) mit der Maßgabe fixierbar ist, dass die Halbleiterscheibe (1) eine Begrenzungswand der Aufnahmekammer (5) bildet und ihre aufnahmekammerseitige Oberfläche (8) von dem Arbeitsmedium (6) beaufschlagbar ist
und wobei zumindest eine Zuführungsleitung (9) für das Arbeitsmedium (6) und zumindest eine Abführungsleitung (10) für das Arbeitsmedium (6) an die Aufnahmekammer (5) angeschlossen ist und die Aufnahmekammer (5) ansonsten geschlossen ausgebildet ist.

2. Vorrichtung nach Anspruch 1, wobei der Grundkörper (2) plattenförmig ausgebildet ist und wobei die Breite b des Aggregates aus Grundkörper (2), Rückwand (3) und Deckel (4) geringer ist als der Durchmesser der Halbleiterscheibe (1), vorzugsweise geringer als die Hälfte des Durchmessers der Halbleiterscheibe (1).

3. Vorrichtung nach einem der Ansprüche 1 oder 2, wobei das Arbeitsmedium (6) über die Zuführungsleitung (9) kontinuierlich zugeführt und über die Abführungsleitung (10) kontinuierlich abgeführt wird und die Aufnahmekammer (5) somit kontinuierlich von dem Arbeitsmedium (6) durchströmt wird.

4. Vorrichtung nach einem der Ansprüche 1 bis 3, wobei die Halbleiterscheibe (1) mit Hilfe einer ersten Dichtungsanordnung (7) aus zwei mit Abstand voneinander angeordneten elastischen Dichtungen (11) am Grundkörper (2) haltbar ist.

5. Vorrichtung nach Anspruch 4, wobei zwischen den beiden elastischen Dichtungen (11) zumindest eine Unterdruckleitung (12) mündet.

6. Vorrichtung nach einem der Ansprüche 1 bis 5, wobei der Deckel (4) mit Hilfe einer zweiten, konzentrisch um die erste Dichtungsanordnung (7) herum angeordneten Dichtungsanordnung (13) am Grundkörper (2) gehalten ist.

7. Vorrichtung nach einem der Ansprüche 1 bis 6, wobei die Rückwand (3) lösbar am Grundkörper (2) gehalten ist.

8. Vorrichtung nach einem der Ansprüche 1 bis 7, wobei der Deckel (4) und/oder die Rückwand (3) über Schraubverbindungen (25) mit dem Grundkörper (2) verbunden ist.

9. Vorrichtung nach einem der Ansprüche 1 bis 8, wobei die Halbleiterscheibe (1) zwischen Deckel (4) und Aufnahmekammer (5) angeordnet ist.

10. Vorrichtung nach einem der Ansprüche 1 bis 9, wobei die Halbleiterscheibe (1) als Elektrode geschaltet ist und in der Aufnahmekammer (5) eine Gegenelektrode (18) angeordnet ist.

11. Vorrichtung nach einem der Ansprüche 1 bis 10, wobei die Vorrichtung zum einseitigen Behandeln einer Halbleiterscheibe (1) vorgesehen ist und lediglich eine Aufnahmekammer (5) aufweist und nur die aufnahmekammerseitige Oberfläche der Halbleiterscheibe (1) von dem Arbeitsmedium (6) beaufschlagbar ist.

12. Vorrichtung nach einem der Ansprüche 1 bis 10, wobei die Vorrichtung zum beidseitigen Behandeln einer Halbleiterscheibe (1) vorgesehen ist und die Halbleiterscheibe (1) als Begrenzungswand zwei Aufnahmekammern (5) trennt, so dass beide aufnahmekammerseitigen Oberflächen der Halbleiterscheibe (1) von dem Arbeitsmedium beaufschlagbar sind.
